# EUROPÄISCHE PATENTSCHRIFT

(11) **EP 0 830 727 B1**
(45) Veröffentlichungstag und Bekanntmachung des Hinweises auf die Patenterteilung: **04.08.1999**
(21) Anmeldenummer: 96919589.0
(22) Anmeldetag: 28.05.1996
(51) Int. Cl.: H03F 1/26, H04B 1/06

(54) **KÜHLVORRICHTUNG FÜR EINEN HOCHFREQUENZEMPFÄNGER**
COOLING DEVICE FOR A HIGH-FREQUENCY RECEIVER
DISPOSITIF DE REFROIDISSEMENT DESTINE A UN RECEPTEUR HAUTE FREQUENCE

(30) Priorität: 03.06.1995 DE 19520506
(43) Veröffentlichungstag der Anmeldung: 25.03.1998
(73) Patentinhaber: ROBERT BOSCH GMBH, 70442 Stuttgart (DE)
(72) Erfinder: GROTHE, Wolfgang, D-75233 Tiefenbronn (DE); KLAUDA, Matthias, D-91056 Erlangen (DE); SCHMIDT, Claus, D-71106 Magstadt (DE)
(86) Internationale Anmeldenummer: DE9600922
(87) Internationale Veröffentlichungsnummer: WO9639742

(56) Entgegenhaltungen:
- US-A- 3 203 477
- US-A- 5 335 505
- RCA REVIEW, Bd. 42, Nr. 4, Dezember 1981, PRINCETON,NJ,US, Seiten 661-671, XP002011708 ASKEW ET AL: "A Low Noise Peltier-cooled FET Amplifier"

## Beschreibung

Die Erfindung geht aus von einer Kühlvorrichtung nach der Gattung des Hauptanspruchs.

Das den Empfang schwacher Signale begrenzende Rauschen eines Hochfrequenzempfängers entsteht größtenteils in den ohmschen Anteilen des Eingangskreises bzw. Eingangsfilters sowie in der darauffolgenden Verstärkerstufe. Je nach Aufbau dieser Bauteile im einzelnen betrifft dieses auch die Abschirm-bzw. Masseflächen. Das Rauschen läßt sich durch Kühlung auf Temperaturen von beispielsweise unter 80 K auf ein Drittel reduzieren.

Aus Dokument US-A-3203477 ist eine Kühlvorrichtung bekannt, die für einen Vorverstärker Verwendung findet, der dadurch besonders rauscharm wird.

Der Artikel aus RCA REVIEW (Bd. 42, Nr. 4, Dezember 1981, seiten 661-671) "A Low Noise Peltier-cooled FET Amplifier" zeigt und beschreibt einen rauscharmen Verstärker für Satellitenanwendungen. Hier wird eine Kühlung des Verstärkers mit einem Peltier-Element vorgenommen, wobei Peltier-Elemente den Nachteil haben, daß sie einen relativ schlechten Wirkungsgrad aufweisen.

Aufgabe der Erfindung ist es, eine Kühlvorrichtung anzugeben, mit deren Hilfe das Rauschen eines Hochfrequenzempfängers wesentlich verringert wird, wobei die zur Kühlung erforderliche Leistung und der Aufwand zur Isolierung der zu kühlenden Bauteile möglichst gering sein sollen.

Diese Aufgabe wird erfindungsgemäß durch die Merkmale des Anspruchs 1 gelöst.

Je nach Voraussetzungen im einzelnen kann der Eingangskreis ein Eingangsfilter und/oder eine Verstärkerstufe, insbesondere einen Transistor, enthalten.

Die erfindungsgemäße Kühlvorrichtung hat den Vorteil, daß die zu kühlenden Bauteile ein äußerst geringes Volumen einnehmen, das mit geringem Aufwand gegenüber der Umgebung thermisch isoliert werden kann, wodurch auch die aufzubringende Kühlleistung gering wird.

Dieses geringe Volumen ist ferner wesentlich leichter gegen Eindringen von Feuchtigkeit zu sichern, die eine Vereisung von Hohlräumen bzw. Oberflächen innerhalb des zu kühlenden Bereichs und damit eine Beeinträchtigung der Funktion des Hochfrequenzempfängers zur Folge hätte.

Eine Kühlung mit der erfindungsgemäße Vorrichtung führt je nach eingesetzter Kühlleistung zu einer erheblichen Reduzierung des Rauschens. Dadurch kann beispielsweise die Teilnehmerzahl und/oder die Zellengröße eines digitalen Mobilfunknetzes deutlich erhöht werden.

Bei Hochfrequenzempfängern im allgemeinen und bei insbesondere solchen, die an unzugänglichen Stellen betrieben werden, sind große Wartungsintervalle und eine hohe Zuverlässigkeit besonders wichtig. Deshalb ist bei einer Weiterbildung der erfindungsgemäßen Vorrichtung vorgesehen, daß der Kleinkühler auf der kühlenden Seite keine bewegten Teile aufweist. Dabei ist der Kleinkühler ein Stoßwellenkühler.

Diese Weiterbildungen sind besonders vorteilhaft, da bei stark gekühlten mechanisch bewegten Teilen der Einsatz von Schmiermitteln problematisch bis unmöglich ist. Geeignete Stoßwellenkühler sind beispielsweise in dem Aufsatz von Ray Radebaugh: "A Review of Pulse Tube Refrigeration", Advances of Cryogenic Engineering, Vol. 35, Plenum Press, New York 1990, Seiten 1191 bis 1205 und in Datenbättern der Firma Iwatani; International Corporation, Tokio "New CryoMini PTRE", 1994.2 und "Main Specifications of "NEW PTRE" Model P201", 04/95 beschrieben.

Ausführungsbeispiele der Erfindung sind in der Zeichnung anhand mehrerer Figuren dargestellt und in der nachfolgenden Beschreibung näher erläutert. Es zeigt:
- Fig. 1: eine schematische Darstellung eines ersten Ausführungsbeispiels und
- Fig. 2: eines zweiten Ausführungsbeispiels.

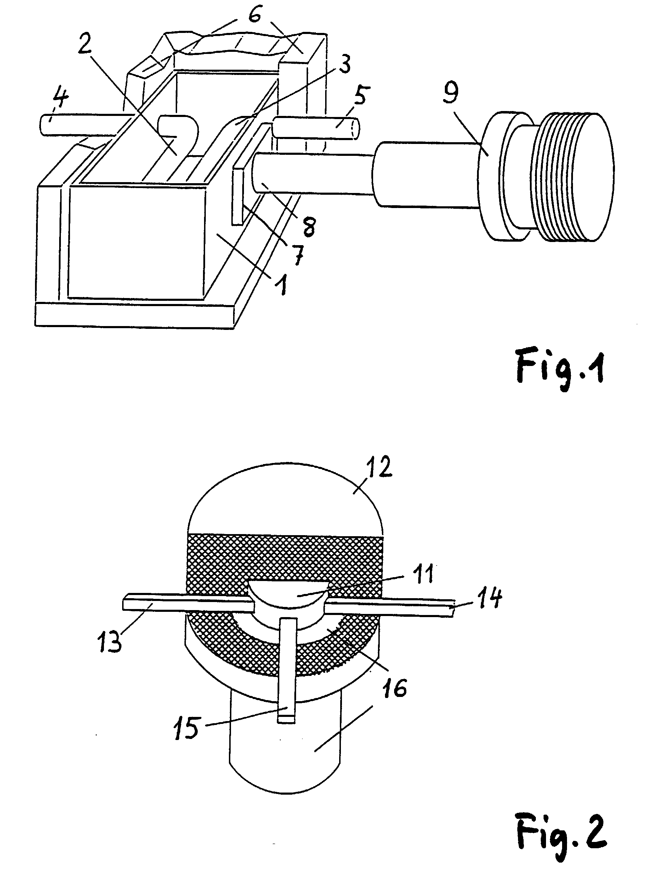

Bei dem Ausführungsbeispiel nach Fig. 1 ist das zu kühlende Bauteil ein Filter mit einem Gehäuse 1 und Filterelementen 2, 3. Die zu filternden Signale werden bei 4 zugeführt und die gefilterten bei 5 entnommen. Das Gehäuse 1 ist von einer Wärmeisolierung 6 umgeben, die aus einem geeigneten Werkstoff, beispielsweise Styropor, besteht und in Fig. 1 aufgebrochen dargestellt ist, um einen Blick auf das Filter zu ermöglichen.

Zur Abführung der Wärme vom Gehäuse 1, das vorzugsweise aus Kupfer besteht, ist über eine Platte 7 eine Wärmeleitung 8 in Form eines vorzugsweise ebenfalls aus Kupfer bestehenden Zylinders angeschlossen. Eine an sich erforderliche Wärmeisolierung des Wärmeleiters 8 ist der Übersichtlichkeit halber in Fig. 1 nicht dargestellt. Das andere Ende des Wärmeleiters 8 ist mit der kalten Seite eines Stoßwellenkühlers 9 verbunden. Der Stoßwellenkühler ist beispielsweise aus dem obengenannten Aufsatz bekannt und braucht zur Erläuterung der Erfindung nicht im einzelnen beschrieben zu werden.

Beim Ausführungsbeispiel nach Fig. 2 ist das zu kühlende Bauteil ein Hochfrequenz-Transistor 11, der beispielsweise die erste Verstärkerstufe eines Empfängers bildet. Der Transistor 11 ist vollständig von einer Wärmeisolierung 12 umschlossen, aus der lediglich die Anschlüsse 13, 14, 15 herausragen. Der Transistor steht über einen Wärmeleiter 16 mit einem nicht dargestellten Kleinkühler in wärmeleitender Verbindung. Auch bei Fig. 2 wurde auf eine Darstellung der Wärmeisolierung des Wärmeleiters 16 verzichtet und die Wärmeisolierung 12 des Transistors aufgebrochen dargestellt.

## Patentansprüche

1. Kühlvorrichtung mit einem Hochfrequenzempfänger mit einem Eingangskreis (1,2,3,11), der noch nicht ausreichend verstärkte Signale führt und der thermisch mit einem Kleinkühler (9) verbunden ist, dadurch gekennzeichnet, daß der Eingangskreis (1,2,3,11) einschließlich eines Kälteausgangs des Kleinkühlers (9) gegenüber der Umgebung thermisch isoliert ist und daß der Kleinkühler als Stoßwellenkühler ausgebildet ist.

2. Kühlvorrichtung nach Anspruch 1, dadurch gekennzeichnet, daß der Eingangskreis ein Eingangsfilter (1,2,3) enthält.

3. Kühlvorrichtung nach einem der Ansprüche 1 oder 2, dadurch gekennzeichnet, daß der Eingangskreis eine Verstärkerstufe, insbesondere einen Transistor (11) enthält.

## Claims

1. Cooling device with a radio-frequency receiver with an input circuit (1, 2, 3, 11), which carries signals which are not yet sufficiently amplified and is thermally connected to a minicooler (9), characterized in that the input circuit (1, 2, 3, 11), including a cooling output of the minicooler (9), is thermally insulated from the surroundings, and in that the minicooler is designed as a shock wave cooler.

2. Cooling device according to Claim 1, characterized in that the input circuit contains an input filter (1, 2, 3).

3. Cooling device according to either of Claims 1 and 2, characterized in that the input circuit contains an amplifier stage, in particular a transistor (11).

## Revendications

1. Dispositif de refroidissement avec un récepteur à haute fréquence avec un circuit d'entrée (1, 2, 3, 11), qui conduit à des signaux qui ne sont pas encore suffisamment amplifiés, et qui est relié thermiquement à un petit refroidisseur (9),
caractérisé en ce que
le circuit d'entrée (1, 2, 3, 11) est isolé thermiquement y compris une sortie de froid du petit refroidisseur (9) par rapport à l'environnement, et en ce que le petit refroidisseur est constitué sous la forme d'un refroidisseur à ondes de choc.

2. Dispositif de refroidissement selon la revendication 1,
caractérisé en ce que
le circuit d'entrée contient un filtre d'entrée (1, 2, 3).

3. Dispositif de refroidissement selon l'une des revendications 1 ou 2,
caractérisé en ce que
le circuit d'entrée contient un étage d'amplification, en particulier un transistor (11).
